# EUROPÄISCHE PATENTANMELDUNG

(11) **EP 1 152 432 A1**
(43) Veröffentlichungstag der Anmeldung: **07.11.2001**
(21) Anmeldenummer: 01109946.2
(22) Anmeldetag: 24.04.2001
(51) Int. Cl.: G11C 11/4091, G11C 7/06

(54) **Layout eines Sense-Verstärkers mit beschleunigter Signalauswertung**

(30) Priorität: 04.05.2000 DE 10021776
(71) Anmelder: Infineon Technologies AG, 81669 München (DE)
(72) Erfinder: Fischer, Helmut, 82024 Taufkirchen (DE); Markert, Michael, 86152 Augsburg (DE); Schneider, Helmut, 80993 München (DE); Schoeniger, Sabine, 83734 Hausham (DE)
(74) Vertreter: MÜLLER & HOFFMANN Patentanwälte

(57) **Zusammenfassung**

Bei einem Layout einer Senseverstärkeranordnung für einen Halbleiterspeicher mit mehreren sich als Streifen zel1enförmig untereinander erstreckenden Schreib/Lese-Verstärkern (20) mit NMOS- und PMOS-Transistoren ist vorgesehen, daß zumindest einer der beiden Treibertransistoren (N1, P1) mit seinen Dotierungsgebieten zwischen den dazugehörigen NMOS- oder PMOS-Transistoren der Schreib/Lese-Verstärker (N2, N3, P2, P3) angeordnet ist, und daß das Gate des Treibertransistors (N1, P1) dabei als Zweistreifengate (N111, P111) ausgebildet ist, um die Signalauswertung in den Sense-Verstärkern zu beschleunigen

## Beschreibung

Die vorliegende Erfindung betrifft das Layout einer Senseverstärkeranordnung für einen Halbleiterspeicher mit mehreren sich als Streifen zeilenförmig untereinander erstreckenden Schreib/Lese-Verstärkern mit NMOS- und PMOS-Transistoren und mit zwei sich senkrecht dazu als Streifen über mehrere Schreib/Lese-Verstärkerzeilen spaltenförmig erstreckenden Treibertransistoren der Schreib/Lese-Verstärker, sowie mit sich in den Schreib/Lese-Verstärkerzeilen erstreckenden nichtinvertierten und invertierten Bitleitungen.

Derartige Layouts sind allgemein bei Halbleiter-DRAMs bekannt, wobei jeweils zwei Treibertransistoren beim Sensevorgang für die PMOS-Transistoren zahlreicher Schreib/Lese-Verstärker das Signal PCS sowie für die entsprechenden NMOS-Transistoren der zahlreichen Schreib/Lese-Verstärker das Signal NCS bereitstellen. Mit zunehmender Taktfrequenz der DRAMs kommt insbesondere der zügigen Bereitstellung dieses PCS-Signals für den Sensevorgang steigende Bedeutung zu. Je weiter dieses Signal insbesondere beim ersten Lese- oder Schreibzugriff eines Zyklus entwickelt ist, desto schneller erreicht jeweils der von den PMOS-Transistoren entwickelte Senseverstärkerknoten seinen Endwert. Entsprechendes gilt für das NCS-Signal und die von den NMOS-Transistoren entwickelten Knoten der Schreib/Lese-Verstärker.

Aufgabe der vorliegenden Erfindung ist es, die Signalauswertung in den Senseverstärkern zu beschleunigen und beispielsweise die Beschleunigung der Entwicklung der durch die PMOS-Transistoren getriebenen Seite.

Erfindungsgemäß ist dies bei einem Senseverstärker nach dem Oberbegriff des Patentanspruches 1 dadurch erreicht, daß zumindest einer der beiden Treibertransistoren mit seinen Dotierungsgebieten zwischen den dazugehörigen NMOS- oder PMOS-Transistoren der Schreib/Lese-Verstärker angeordnet ist, und daß das Gate des Treibertransistors dabei als Zweistreifengate ausgebildet ist. Durch die erfindungsgemäße Verdoppelung der Weite des Treibertransistors kann die Signalentwicklung im Senseverstärker wesentlich erhöht werden, ohne den Flächenbedarf relevant erhöhen zu müssen. Insbesondere wenn der PCS-Treibertransistor erfindungsgemäß realisiert ist, ist bei deutlich verbesserter Treiberleistung eine kompakte Baugröße realisiert.

Das Einfügen von Querstegen zwischen den beiden Gatestreifen des PCS-Treibertransistors ermöglicht eine Symmetrierung der PCS-Signalversorgung der PMOS-Transistoren der Schreib/Lese-Verstärker, eine Optimierung des Gatewiderstandes des PCS-Treibertransistors und darüber hinaus die Einstellung der Gatekapazität des PCS-Treibertransistors. Entsprechendes gilt für den NCS-Treibertransistor. Auf diese Weise können die Geschwindigkeit der Signalentwicklung einerseits und die NoiseFilterung andererseits anwendungsspezifisch optimiert eingestellt werden. Infolge der platzsparenden "Doppelgatetechnik" ist es auf einfache Weise möglich, jeweils mehrere Gatequerstege vorzusehen. Vorteilhafterweise erstreckt sich der Gatequersteg parallel zum Schreib/Lese-Verstärkerstreifen zumindest in dessen außenseitigen Randbereich, um gleichzeitig eine zusätzliche Kontaktierung des Gates des Treibertransistors einfach realisieren zu können.

Nachfolgend ist anhand schematischer Darstellungen ein Ausführungsbeispiel des erfindungsgemäßen Layouts der Senseverstärkeranordnung eines Halbleiterspeichers beschrieben. Es zeigen:
Fig. 1 ein Prinzipschaltbild eines Halbleiterspeichers,
Fig. 2 ein Prinzipschaltbild eines Sense-Verstärkers des Halbleiterspeichers aus Fig. 1,
Fig. 3 in vereinfachter Darstellung eine Aufsicht auf das Layout der Senseverstärkeranordnung gemäß Fig. 2 gemäß dem Stand der Technik,
Fig. 4 in vereinfachter Darstellung eine Aufsicht auf das erfindungsgemäße Layout der Senseverstärkeranordnung gemäß Fig. 2,
Fig. 5 eine Aufsicht auf einen anderen Abschnitt des erfindungsgemäßen Layouts der Senseverstärkeranordnung aus Figur 4, und
Fig. 6 ein Zeitdiagramm der Signalentwicklung in einem Senseverstärker mit dem erfindungsgemäßen Layout nach Fig. 4.

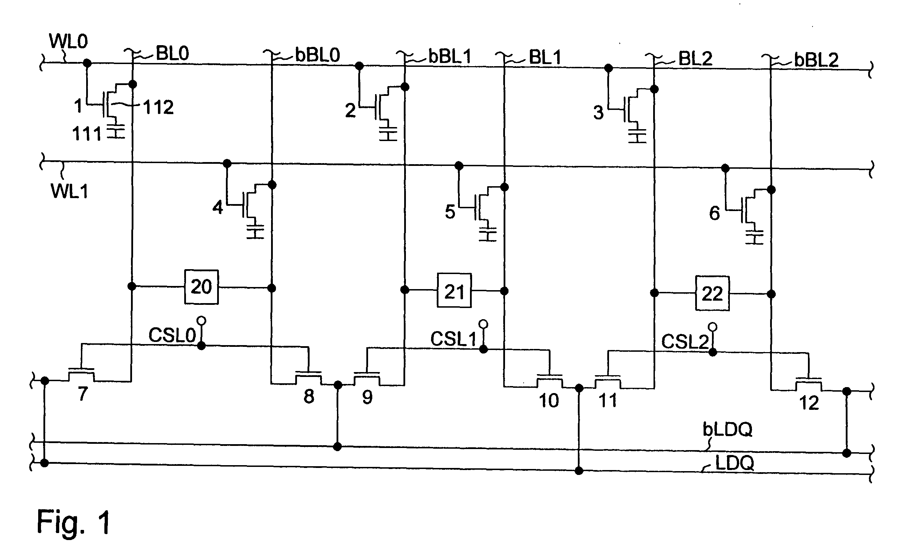

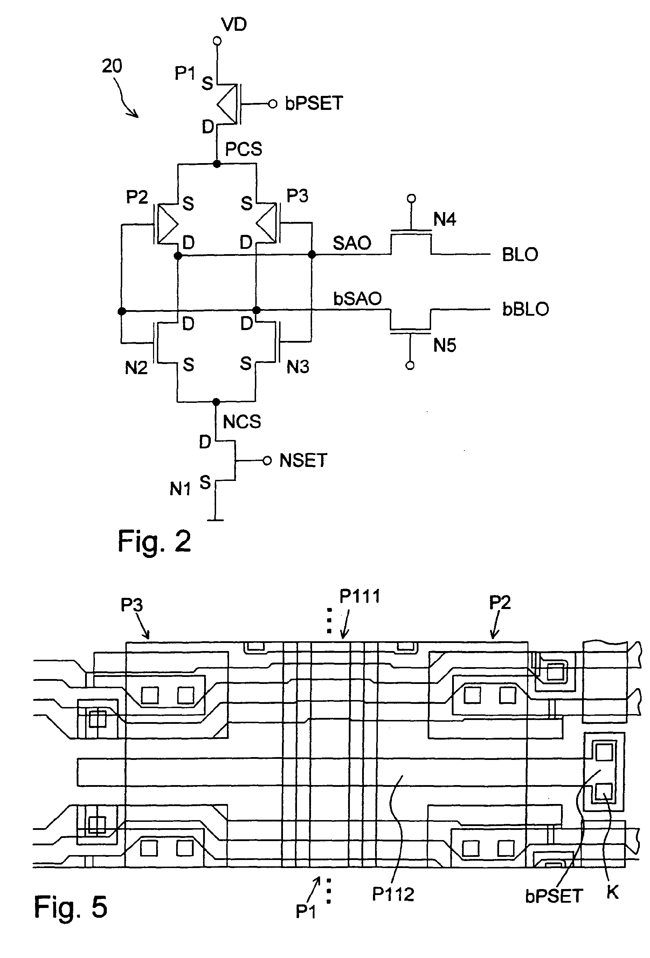

In der Figur 1 ist ein Ausschnitt aus einem Speicherzellenfeld eines Halbleiterspeichers mit Speicherzellen 1, ..., 6 gezeigt. Jede Speicherzelle umfaßt einen Speicherkondensator 111, der an einem Anschluß mit einem Bezugspotential, z.B. Masse, verbunden ist und an dem anderen Anschluß mit dem Drain-Source-Pfad eines MOS-Auswahltransistors 112. Der andere Anschluß des Auswahltransistors 112 ist mit einer Bitleitung, z.B. BL0 verbunden. Zum Einlesen und Auslesen der im Kondensator 111 zu speichernden oder gespeicherten Dateninformation wird durch ein entsprechendes Steuersignal auf einer Wortleitung WL0 der Transistor 112 leitend geschaltet, so daß der Kondensator 111 mit der Bitleitung BL0 leitend verbunden wird. Die Kapazität des Speicherkondensators 111 ist dabei wesentlich kleiner als die Bitleitungskapazität. Die anderen Speicherzellen 2,..., 6 sind entsprechend ausgeführt. Unmittelbar neben der Bitleitung BL0 ist die Bitleitung bBL0 angeordnet. Mit der Bitleitung bBL0 ist die Speicherzelle 4 verbunden, deren Auswahltransistor über eine andere Wortleitung WL1 ansteuerbar ist. Beide Bitleitungen BL0, bBL0 sind eingangs- und ausgangsseitig mit einem Leseverstärker 20 verbunden. Beim Auslesen von Dateninformationen aus den Speicherzellen 1 oder 4 wird das entsprechende Signal aus dem Speicherkondensator 111 an die jeweilige Bitleitung BL0 bzw. bBL0 gelegt und durch den Leseverstärker 20 verstärkt. Der Leseverstärker 20 ist als Schreib/Lese-Verstärker ausgeführt, wie nachfolgend näher beschrieben ist (Figur 2). In der Speicherzelle 1 ist das gespeicherte Informationsbit nichtinvertiert gespeichert, da die Bitleitung BL0 mit dem nichtinvertiert verstärkenden Eingang des Leseverstärkers 20 verbunden ist. Das in der Speicherzelle 4 gespeicherte Informationsbit ist dagegen invertiert gespeichert, da die Bitleitung bBL0 mit dem invertiert verstärkenden Eingang des Leseverstärkers 20 verbunden ist. Entsprechend sind die Speicherzellen 2, 5, 3 und 6, die Bitleitungen BL1, bBL1, BL2 und bBL2 mit den entsprechenden Leseverstärkern 21 und 22 des Halbleiterspeichers nach Figur 1 verbunden. Die Speicherzellen 1, 2, 3 werden von der Wortleitung WL0 ausgewählt, die Speicherzellen 4, 5, 6 von der anderen Wortleitung WL1. Die Bitleitungen verlaufen parallel zueinander. In Betrachtungsrichtung senkrecht zum Verlauf der Wortleitungen W10, WL1 folgt auf eine erste invertierte Bitleitung eine zweite invertierte Bitleitung; auf eine zweite invertierte Bitleitung folgt eine erste nichtinvertierte Bitleitung; auf eine erste nichtinvertierte Bitleitung folgt eine zweite nichtinvertierte Bitleitung. In Abhängigkeit von den anwendungsspezifischen Gegebenheiten können die nichtinvertierten und invertierten Bitleitungen jedoch auch in anderer Reihenfolge angeordnet sein.

Nach dem Verstärkungsvorgang beim Auslesen werden die an den Bitleitungen anliegenden Daten auf zwei Sammelleitungen LDQ, bLDQ ausgegeben. Die nichtinvertierte Sammelleitung LDQ empfängt die Signale der nichtinvertierten Bitleitungen BL0, BL1, BL2. In entsprechender Weise leitet die invertierte Sammelleitung bLDQ die ausgelesene Dateninformation der invertierten Bitleitungen bBL0, bBL1, bBL2 weiter. Die Bitleitungen sind über entsprechende Schalttransistoren 7,...12 mit den Sammelleitungen verbunden. Über die Sammelleitungen wird das ausgelesene Datenbit in Richtung des Ausgangs des Halbleiterspeichers geleitet. Diejenigen Schalttransistoren, die den nebeneinander liegenden sowie an den gleichen Leseverstärker angeschlossenen Bitleitungen zugeordnet sind, werden durch ein gemeinsames Steuersignal CSL0, CSL1 bzw. CSL2 gesteuert. Insgesamt wird also bei einem Auslesevorgang in den Leseverstärker 20 die auszulesende Dateninformation einphasig eingespeist, aber als differentielles Datensignal ausgangsseitig bereitgestellt und differentiell an die Sammelleitungen übergeben. Die Daten von zwei unmittelbar nebeneinander benachbart angeordneten Datenleitungen des gleichen Typs (d.h. beide invertiert oder beide nichtinvertiert) werden auf die gleiche Sammelleitung bLDQ oder LDQ ausgegeben (Figur 1).

Gemäß Figur 2 umfaßt der Senseverstärker 20 in bekannter Weise einen Schreib/Lese-Verstärker mit der Parallelschaltung jeweils zweier in Reihe geschalteter Transistoren vom NMOS-und PMOS-Typ N2, N3, P2, P3. Dabei liegen die in Reihe geschalteten Transistoren P2 und N2 und die in Reihe geschalteten Transistoren P3 und N3 des Schreib/Lese-Verstärkers zwischen Schreib/Lese-Verstärkerknoten NCS und PCS. Die Gates der Transistoren P2 und N2 sind miteinander verbunden. Ebenso sind die Gates der Transistoren P3 und N3 miteinander verbunden. Der Schreib/Lese-Verstärkerknoten NCS ist über den Drain-Source-Pfad eines NMOS-Treibertransistors N1 des Sense-verstärkers 20 mit Masse verbunden. An das Gate des Treibertransistors N1 ist ein Senseverstärker-Steuersignal NSET gelegt. Entsprechend ist der zweite Schreib/Lese-Verstärkerknoten PCS über den Drain-Source-Pfad eines PMOS-Treibertransistors P1 des Senseverstärkers 20 mit einem positiven Versorgungspotential VD des Halbleiterspeichers verbunden. An das Gate des Treibertransistors P1 ist wiederum ein Steuersignal bPSET gelegt. Die Potentiale der Knoten NCS und PCS werden beim Sense-Vorgang also über die Treibertransistoren N1 und P1 entwickelt. In bekannter Weise treiben dabei die beiden in Figur 2 gezeigten Treibertransistoren N1, P1 auch zahlreiche andere Differenz-Verstärker 20, 21, 22, .. und sind deshalb mit zahlreichen Schreib/Lese-Verstärkerknoten NCS, PCS gleichzeitig verbunden (in Figur 2 nicht gezeigt). Die Bitleitungen BL0 und bBL0 des Halbleiterspeichers gemäß Figur 1 sind jeweils über einen NMOS-Abschalttransistor N4, N5 mit dem Senseverstärker 20 verbunden. Die Bitleitung BL0 verbindet dabei die beiden Drains der Schreib/Lese-Verstärker-Transistoren P2, N2 mit den Gates der beiden schaltungstechnisch in Figur 2 gegenüberliegend angeordneten Schreib/Lese-Verstärker-Transistoren P3, N3. Der gemeinsame Knoten SA0 wird als Senseverstärkerknoten bzw. -leitung bezeichnet. Entsprechend verbindet die invertierte Bitleitung bBL0 die Gates der in Reihe geschalteten Transistoren P2, N2 des Schreib/Lese-Verstärkers mit den Drains der Transistoren P3, N3. Der gemeinsame Knoten bSA0 wird ebenfalls als Senseverstärkerknoten bzw. -leitung bezeichnet. Die Funktion des Sense-Verstärkers 20 ist vereinfacht dargestellt folgende. Wird beispielsweise der Senseverstärkerknoten SA0 nach dem Einschalten des Abschalttransistors N4 von der Bitleitung BL0 durch ein Zellsignal und besagte NMOS-Transistoren oder durch ein Schreibsignal in Richtung 0 V gezogen, so leitet der PMOS-Schreib/Lese-Verstärker-Transistor P3. Dadurch wird der invertierte Senseverstärkerknoten bSA0 auf das an den Eingang PCS gelegte Signal, z.B. 1,8 V, gezogen. Dabei wird das Signal PCS von dem PMOS-Treibertransistor P1 bereitgestellt, der durch das Signal bPSET entsprechend angesteuert wird. Entsprechendes gilt für die NCS-Seite.

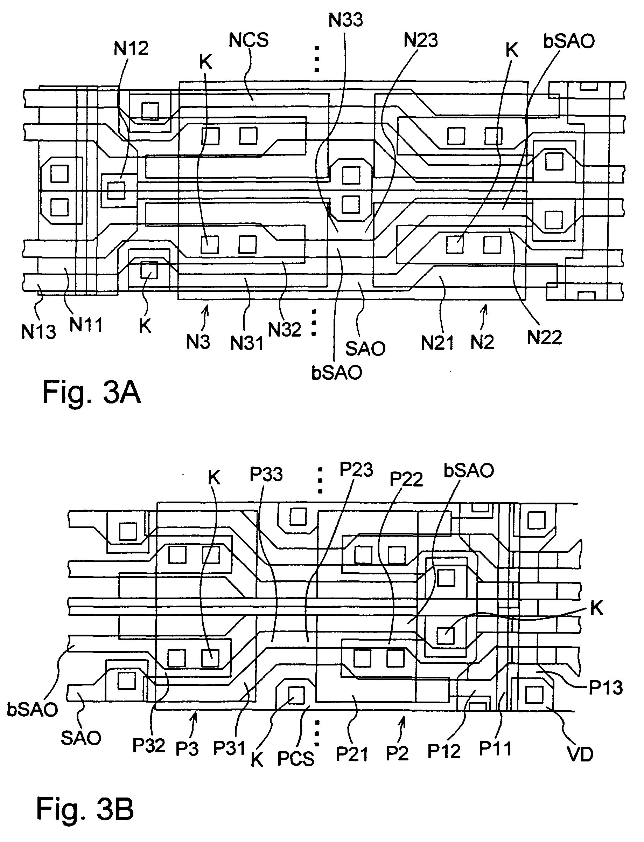

Ein bekanntes Layout des Halbleiterspeichers mit Senseverstärkern entsprechend dem Verstärker 20 aus den Figuren 1 und 2 gemäß dem Stand der Technik ist in Figur 3 gezeigt. Dabei sind aus Vereinfachungsgründen lediglich zwei der zahlreichen Schreib/Lese-Verstärkerzeilen dargestellt. Es sind untereinander sich von links nach rechts als Streifen zeilenförmig erstreckende Schreib/Lese-Verstärker mit den dazugehörigen Schaltungselementen bzw. deren Dotierungs- und Metallisierungsgebiete angeordnet. Senkrecht dazu fassen die beiden sich von oben nach unten links und rechts randseitig der zahlreichen Schreib/Lese-Verstärker als Streifen spaltenförmig erstreckenden Treibertransistoren N1, P1 die jeweiligen Schreib/Lese-Verstärkertransistoren N2, N3, P2, P3 der Schreib/Lese-Verstärkerzeilen ein. Die Dotierungs- bzw. Metallisierungsgebiete von Gate N11, Drain N12 und Source N13 des Treibertranssistors N1 sind dabei jeweils entsprechend senkrecht verlaufend angeordnet. Entsprechendes gilt für Gate P11, Drain P12 und Source P13 des gegenüberliegend angeordneten PMOS-Treibertransistors P1. Die sich an die Streifen des Treibertransistors P1 innenseitig anschließenden C-förmigen und gespiegelt C-förmigen Strukturen sind die Gates P21, P31 der PMOS-Transistoren P2, P3 des Schreib/Lese-Verstärkers. Im Inneren der Gates P21, P31 erstrecken sich die Draingebiete P22, P32 der PMOS-Transistoren P2, P3. Die Gates P21, P31 sind wiederum von den Source-Dotierungsgebieten P23, P33 der PMOS-Transistoren P2, P3 umgeben. Von links nach rechts in Figur 3 erstrecken sich die beiden Bitleitungen BL0, bBL0 bzw. die beiden Senseverstärkerleitungen SA0, bSA0. Die verschiedenen Schaltungselemente des Senseverstärkers 20 sind über Leitungsstreifen und Kontakte K entsprechend dem Prinzipschaltbild in Figur 2 miteinander verschaltet. Links neben der PMOS-Seite des Schreib/Lese-Verstärkers schließen sich die entsprechend (gemäß Figur 2) verschalteten NMOS-Transistoren N2, N3 sowie die senkrecht dazu verlaufenden Streifen des NCS-Treibertransistors N1 mit deren Dotierungs- und Metallisierungsgebieten N11, N12, N13, N21, N22, N23, N31, N32 und N33 an.

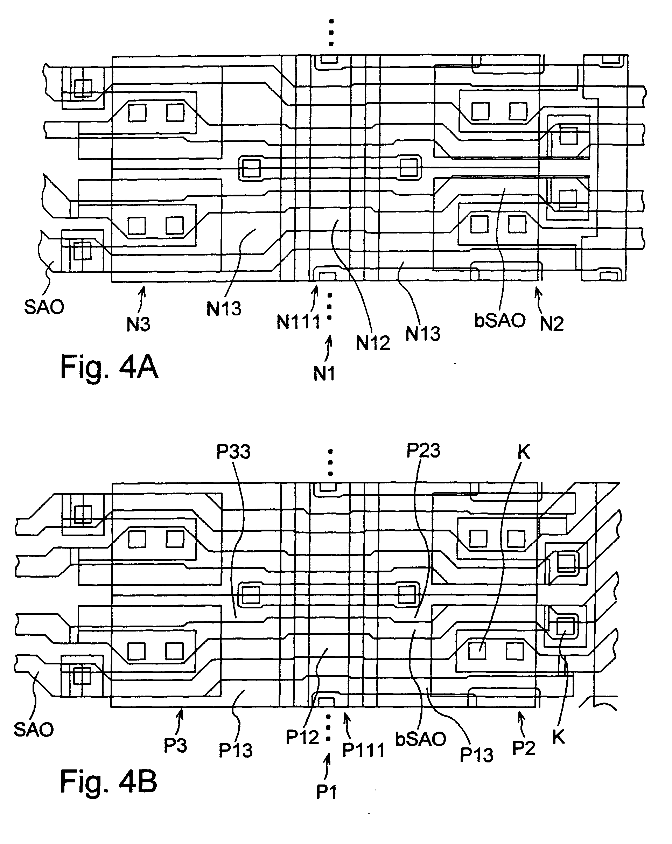

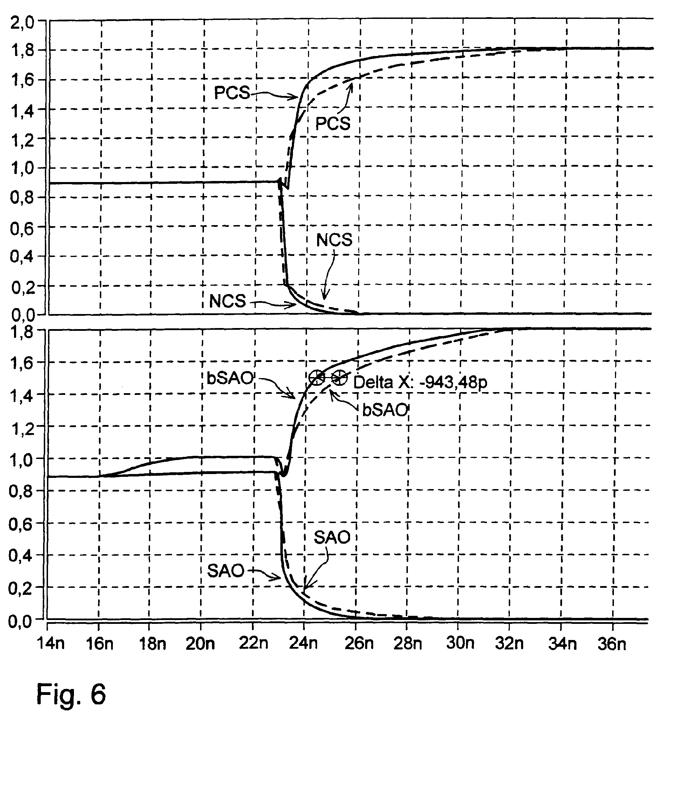

Figur 4 zeigt das gegenüber Figur 3 verbesserte erfindungsgemäße Layout der Senseverstärkeranordnung. Dabei sind aus Vereinfachungsgründen wiederum lediglich zwei der zahlreichen Schreib/Lese-Verstärkerzeilen dargestellt. Der Treibertransistor P1 ist gemäß Figur 4 in die Mitte zwischen die beiden PMOS-Transistoren P2 und P3 des Schreib/Lese-Verstärkers 20 und den entsprechenden PMOS-Transistoren der unter- und oberhalb des Schreib/Lese-Verstärkers 20 angeordneten weiteren Schreib/Lese-Verstärkern des Halbleiterspeichers gelegt. Der Treibertransistor P1 erstreckt sich senkrecht zu den Schreib/Lese-Verstärkerzeilen in Figur 4 von oben nach unten. Dabei ist der Treibertransistor P1 mit einem Zweistreifengate P111 ausgebildet. Zwischen diesen beiden sich streifenförmig von oben nach unten erstreckenden, beabstandeten Teilgates ist das Drain P12 des Treibertransistors P1 angeordnet. Abhängig von anwendungsspezifischen Wünschen können die beiden Teilgates auch abschnittsweise abgewinkelt oder mit unterschiedlichen Abständen angeordnet sein. Links und rechts der beiden Teilgates P111 verlaufen die Dotierungsgebiete des Sources P13 des Treibertransistors P1, die zugleich die Sourcegebiete P23, P33 der PMOS-Schreib/Lese-Verstärkertransistoren P2, P3 bilden. Das Source P13 des Treibertransistors P1 ist über PCS-Streifen mit den Sources P23, P33 verbunden. Weiterhin sind mit entsprechenden Kontakten K und Leitungsstreifen die Transistoren des Senseverstärkers 20 gemäß dem Prinzipschaltbild in Figur 2 mit sich und den beiden Bitleitungen BL0, bBL0 bzw. den beiden Senseverstärkerleitungen SA0, bSA0 verschaltet. Entsprechendes gilt für die N-Seite des Senseverstärkers 20, wobei die Weiten der NMOS-Schreib/Lese-Verstärkertransistoren N2, N3 im Vergleich zum in Figur 3 gezeigten Layout deutlich reduziert sind. Durch das in Figur 4 gezeigte Layout ist eine Verdoppelung der Weiten des NCS- und insbesondere des PCS-Treibertransistors P1 ermöglicht, ohne daß die für den Senseverstärker 20 benötigte Fläche nennenswert zunimmt. Durch diese Verdoppelung der PCS-Treiberfähigkeit kann einerseits die Signalentwicklung im Senseverstärker 20 bzw. im Schreib/Lese-Verstärker und allen anderen gleichzeitig durch den Treibertransistor P1 getriebenen Schreib/Lese-Verstärkern erheblich beschleunigt werden, was in Figur 6 beschrieben ist. Andererseits kann der effektive Flächenbedarf durch eine kleinere Dimensionierung der Weite der NMOS-Transistoren N2, N3 in den Schreib/Lese-Verstärkern nochmals reduziert werden. Diese Weitenreduktion des NMOS-Senseverstärkers inklusive einer der PMOS-Seite des Senseverstärkers entsprechenden Anordnung des NCS-Treibertransistors N1 ist in Figur 4 auf der linken Seite gezeigt.

Das Einfügen eines Gatequersteges 112, der die beiden Streifen des Zweistreifengates 111 des Treibertransistors P1 in Abwandlung von der Darstellung in Figur 4 miteinander verbindet, ist beispielhaft in Figur 5 gezeigt. Diese Maßnahme führt einerseits zu einer Symmetrierung der PCS-Signalversorgung der PMOS-Transistoren des Schreib/Lese-Verstärkers und ermöglicht darüber hinaus eine Optimierung der kapazitiven Last des Ansteuersignals. Durch diese Lastveränderung kann die Flankensteilheit des Ansteuersignals optimiert werden. Zusätzlich wird durch die Querstege die geometrische Symmetrie der Sensetransistoren sichergestellt, wodurch eine Neigung zum Kippen in eine Richtung unterdrückt, und somit der Sensevorgang schon bei kleineren Eingangspegeln, also auch noch schneller, sichergestellt werden kann. Der Gatequersteg 112 erstreckt sich von links nach rechts bis in den Randbereich des in Figur 5 rechts dargestellten Schreib/Lese-Verstärker-Transistors P2. Dadurch ist über die Kontakte K ein einfaches Zuführen des bPSET-Signals an das Gate P11 des Treibertransistors P1 ermöglicht.

In Figur 6 sind Simulationsergebnisse der Signalentwicklung bei einem Leseverstärkungsvorgang im Senseverstärker 20 mit dem Layout nach dem bekannten Stand der Technik (Figur 3) und dem erfindungsgemäßen Layout (Figur 4, 5) vergleichend gegenübergestellt. Dabei sind die Signalentwicklungen bei einem Senseverstärker mit einem Layout nach Figur 3 in gepunkteten Linien und bei einem Senseverstärker mit dem erfindungsgemäßen Layout nach Figur 4 in durchgezogenen Linien dargestellt. In einem Vorladezustand sind die Potentiale der Senseverstärkerleitung SA0, bSA0 gleich groß und betragen z.B. etwa 0,9 V. Mit dem Einschalten der Wortleitung WL0 bildet sich zwischen den beiden Bitleitungen BL0 und bBL0 bzw. an den beiden Senseverstärkerknoten SA0 und bSA0 eine kleine Spannungsdifferenz von beispielsweise etwa 80 mV aus. Mit dem Steuersignal NSET wird das Potential des Schreib/Lese-Verstärkerknotens NCS von etwa 0,9 V auf 0 V gezogen. Entsprechend wird über den Schreib/Lese-Verstärker nun auch der Senseverstärkerknoten SA0 geringfügig verzögert auf 0 V gezogen. Der Schreib/Lese-Verstärkerknoten PCS entwickelt sich entsprechend auf 1,8 V und ihm folgend wird der Senseverstärkerknoten bSA0 ebenfalls auf 1,8 V gezogen. Dabei entsteht gemäß dem Ausführungsbeispiel das Steuersignal bPSET aus dem Steuersignal NSET. Bedingt durch das erfindungsgemäße Layout des Senseverstärkers nach Figur 4 entwickelt sich gemäß Figur 6 die durch die PMOS-Transistoren P1, P2, P3 entwickelte Seite um bis zu 1 ns schneller im Vergleich zum Stand der Technik mit dem Layout gemäß Figur 3.

## Patentansprüche

1. Layout einer Senseverstärkeranordnung für einen Halbleiterspeicher mit mehreren sich als Streifen zeilenförmig untereinander erstreckenden Schreib/Lese-Verstärkern mit NMOS- und PMOS-Transistoren (N2, N3, P2, P3) und mit zwei sich senkrecht dazu als Streifen über mehrere Schreib/Lese-Verstärkerzeilen spaltenförmig erstreckenden Treibertransistoren (N1, P1) der Schreib/Lese-Verstärker, sowie mit sich in den Schreib/Lese-Verstärkerzeilen erstreckenden nichtinvertierten und invertierten Bitleitungen (BL0, bBL0), **dadurch gekennzeichnet, daß** zumindest einer der beiden Treibertransistoren (N1, P1) mit seinen Dotierungsgebieten zwischen den dazugehörigen NMOS- oder PMOS-Transistoren der Schreib/Lese-Verstärker (N2, N3, P2, P3) angeordnet ist, und daß das Gate dieses Treibertransistors (N1, P1) als Zweistreifengate (N111, P111) ausgebildet ist.

2. Layout einer Senseverstärkeranordnung nach Anspruch 1, **dadurch gekennzeichnet, daß** die beiden Streifen des Zweistreifengates (N111, P111) des Treibertransistors (N1, P1) über einen Teil dessen Kanalweite mittels Gatequerstegen (N112, P112) miteinander leitend verbunden sind.

3. Layout einer Senseverstärkeranordnung nach Anspruch 2, **dadurch gekennzeichnet, daß** sich der Gatequersteg (N112, P112) parallel zum Schreib/Lese-Verstärkerstreifen zumindest in dessen außenseitigen Randbereich erstreckt.

4. Senseverstärkeranordnung mit einem Layout nach einem der Ansprüche 1 bis 3.
